# EUROPÄISCHE PATENTSCHRIFT

(11) **EP 1 443 654 B1**
(45) Veröffentlichungstag und Bekanntmachung des Hinweises auf die Patenterteilung: **28.05.2008**
(21) Anmeldenummer: 03027196.9
(22) Anmeldetag: 27.11.2003
(51) Int. Cl.: H03M 1/48

(54) **Verfahren und Schaltung zur Wandlung eines analogen Istsignals in ein digitales Sollsignal**
Method and circuit for converting an analogue actual value into a digital setpoint value
Procédé et circuit pour la conversion d'une valeur consignée analogique en une valeur de consigne numérique

(30) Priorität: 29.01.2003 DE 10303347
(43) Veröffentlichungstag der Anmeldung: 04.08.2004
(73) Patentinhaber: EADS Deutschland GmbH, 85521 Ottobrunn (DE)
(72) Erfinder: Böhm, Heinrich-Martin, 85716 Unterschleissheim (DE)
(74) Vertreter: Meel, Thomas

(56) Entgegenhaltungen:
- EP-A- 0 249 986
- EP-A- 0 729 236
- US-A- 4 553 128
- US-A- 4 777 470
- US-A- 4 829 302
- US-A- 6 163 291
- US-B1- 6 329 938

## Beschreibung

Die Erfindung betrifft ein Verfahren zur Wandlung eines analogen Istsignals in ein digitales Sollsignal gemäß dem Oberbegriff des Patentanspruchs 1.

Es sind RF-systeme mit RF-(radio frequency) Verstärkern umfassend Detektoren, z.B. rf-Detektoren oder Stromsensoren, zur Überwachung des Sende- und Empfangsbetriebs bekannt. Ein detektiertes Videosignal ist dabei ein Abbild der empfangenen rf-Puls. Diese rf-Pulse werden von Analogkomparatoren gegen eine Referenzschwelle überwacht. Der Ausgang dieser Komparatoren wird analysiert und das Ergebnis üblicherweise über serielle Schnittstellen zur Weiterverarbeitung weitergeleitet.

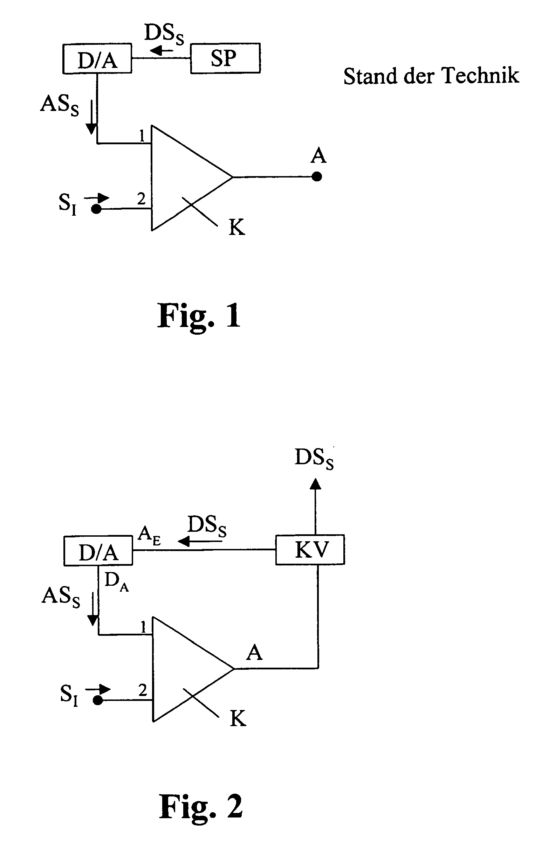

Die Analogkomparatoren K sind üblicherweise programmierbare Komparatoren K, welche die Referenzschwelle, das analoge Sollsignal AS_{S}, intern mittels eines eingebauten Digital-/Analog-Wandlers D/A generieren. Die entsprechenden Digitalwerte DS_{S} für das analoge Sollsignal AS_{S} sind in einem bekannten Speichermedium SP, z.B. ein EPROM, gespeichert und werden je nach Betriebsart des Komparators K in den entsprechenden Komparatoreingang 1 geschrieben. Das analoge Istsignal S_{I} wird dem anderen Komparatoreingang 2 zugeführt. Am Komparatorausgang A kann festgestellt werden, ob das Istsignal I_{S} größer oder kleiner als das Sollsignal AS_{S} ist. (Fig. 1)

Ein A/D-Wandler welcher ein analoges Istsignal in ein digitales Sollsignal wandelt, wobei die Wandlung mittels sukzessiver Approximation gemäß dem Oberbegriff des Anspruchs 1 erfolgt ist aus EP 0 729 236 A1 bekannt. Ein weiterer A/D-Wandler ist aus US 6,329,938 B1 bekannt.

Zur Kalibrierung der Detektoren wird die zu überwachende rf-Leistung mit z.B. einem RF-Powermeter (sogenannten Peak-Power-Analyer) gemessen. Gleichzeitig muß für denselben rf-Puls die detektierte Spannung am Detektor gemessen werden. Letzteres erfolgt üblicherweise mit einem Oszilloskop, wobei die Messung der Spannung am Ausgangspin des zu jeweiligen Komparators erfolgt.

Hierbei ist insbesondere der bau- und zeitaufwendige Messvorgang am Komparatorausgang nachteilig. Üblicherweise stehen am Ausgang des Komparators keine Prüfpins oder externe Steckverbindungen zur Verfügung, da dies einen erheblichen Mehraufwand bei der Produktion bedeutet. Somit muß zu Prüfzwecken oft das Gesamtgerät umgebaut, z.B. geöffnet werden um z.B. mittels Probe das Istsignal am Komparatoreingang zu erfassen. Dabei entstehen Messunsicherheiten aufgrund von Toleranzen beim Messzeitpunkt mit dem Oszilloskop und Messfehler durch z.B. eingekoppelte Störungen, welche das Istsignal verfälschen. Diese Messunsicherheiten führen somit zu Nachteilen bei der Kalibrierung der Detektoren.

Weitere Nachteile ergeben sich daraus, dass bestimmte unter Umständen Detektoren bei verschiedenem Temperaturen und somit in Klimakammern kalibriert werden müssen. Hierbei wird die Adaption der Prüfsignale an den Detektoren weiter erschwert.

Aufgabe der Erfindung ist es, ein einfaches, schnelles und möglichst automatisches Verfahren zur Wandlung eines analogen Istsignals in ein digitales Sollsignal anzugeben, womit eine adaptive Kalibrierung von Detektoren möglich ist.

Diese Aufgabe wird mit dem Verfahren gemäß Patentanspruch 1 gelöst. Vorteilhafte Ausführungen der Erfindung sind Gegenstand von Unteransprüchen.

Erfindungsgemäß wird dem Komparator ein vorgebbarer Referenzpuls aus einem Burst zugeführt. Im Komparator wird von diesem Referenzpuls der der Pulsmitte entsprechende Signalwert verarbeitet. Weiterhin umfasst erfindungsgemäß das analoge Istsignal, also das zu wandelnde Signal, einen Burst mit einer vorgebbaren Anzahl von Pulsen.

Bei dem erfindungsgemäßen Verfahren wird die Referenzschwelle in Abhängigkeit der Zahl der vorgebbaren Iterationsschritte binär aufbereitet. Vorteilhaft entspricht die Zahl der Iterationsschritte der Bitlänge mit der das digitale Sollsignal angegeben werden soll. Mit einer großen Zahl von Iterationsschritten kann somit die Genauigkeit des Sollsignals und somit der Referenzschwelle angeben werden. Somit wird bei einer Zahl von 8 Iterationsschritten das analoge Istsignal mit einer 8-Bit Auflösung nachgebildet. Die Nachbildung erfolgt dabei Bit für Bit gemäß dem bekannten Wägeverfahren, bei welchem die am Komparator anliegende Spannung in mehreren Schritten sukzessive approximiert wird. Ein solches Verfahren ist in der Digitaltechnik neben dem Parallelverfahren und dem Zählverfahren ein bekanntes Verfahren bei der Realisierung von A/D- und/oder D/A-Wandlern.

Ein Vorteil des erfindungsgemäßen Verfahrens ist, dass auf die Prüfung mittels Oszilloskop und dessen externe Adaption verzichtet werden kann. Auch weitere zeit- und kostenintensive Umbaumaßnahmen entfallen bei dem erfindungsgemäßen Verfahren. Die Kalibrierung kann z.B. einfach und schnell ohne Umbaumaßnahmen in einer Klimakammer durchgeführt werden.

Erfindungsgemäß umfasst das analoge Istsignal einen Burst mit mehreren Pulsen vorgebbarer Pulslänge. Die Pulslänge kann z.B. im Bereich von nur einigen µs liegen. Ein Burst kann jede beliebige Anzahl von Pulsen, (z.B. 268 Pulse) umfassen.

Durch die aufeinanderfolgende Pulse kann es z.B. bei RF-Leistungstransistoren aufgrund von Erwärmung zu einer Veränderung des Istsignals währende des Bursts kommen (sogenannter Burst droop). Bei Messungen hat sich in überraschender Weise ergeben, dass sich beim regelmäßigen Senden von Bursts für immer dieselben Pulse im Burst gleiche Verhältnisse (konstanter Istwert) ergeben. Das Istsignal wird am Komparator erfindungsgemäß für einen vorgebbaren Referenzpuls aus dem Burst betrachtet. Darüber hinaus wird von diesem Referenzpuls der der Pulsmitte entsprechende Signalwert im Komparator verarbeitet.

Somit wird beim kontinuierlichen Betrieb von z.B. Burst n bis Burst n+8 bei Puls m der analoge Istwert in einen digitalen Sollwert nachgebildet.

Durch EMV-Störungen, (z.B. sogenannte Spikes), kann das erzeugte digitale Sollsignal verfälscht sein. In einer vorteilhaften Ausführung der Erfindung wird in zwei weiteren Iterationsschritten Burst n+9 und Burst n+10 eine Verifikation des digitalen Sollsignals durchgeführt. Dabei wird in einem ersten Schritt von dem gewonnenen digitalen Sollsignal ein vorgebbarer Signalwert, z.B. 10% des typischen Maximalwertes, abgezogen. Dies erfolgt nur wenn das digitale Sollsignal zuvor einen entsprechend hohen Wert aufwies. Beim Vergleich von aktuellem Istsignal (am Referenzpuls) mit dem um die Differenz vermindertem Sollsignal muss eine Überschreitung auftreten. Ist dies nicht der Fall, wird der gewonnene Sollwert für diesen Zyklus verworfen. In einem Statusbit wird das entsprechende Ergebnis festgehalten.
Im letzten Schritt (Burst n+10) wird dem Sollsignal zuvor ein vorgebbarer Signalwert, z.B. 10% des typischen Maximalwertes aufaddiert, wenn der Wert kleiner als der Maximalwert ist. Beim Vergleich von aktuellem Istsignal (am Referenzpuls) mit dem um die Differenz vermindertem Sollsignal muss eine Unterschreitung auftreten. Ist dies nicht der Fall, wird der gewonnene Sollwert für diesen Zyklus verworfen. In einem Statusbit wird das entsprechende Ergebnis festgehalten.

Die somit gewonnenen Sollwerte inklusive Bewertung durch Statusbits werden durch ein vorhandenes Bussystem vom Prüfling an einen externen Prüfrechner geleitet. Dieser berechnet je nach Anforderungen und Daten die aus anderen Quellen (z.B. PeakPowerMeter) stammen individuelle Sollwerte als Betriebsschwellen. Die Werte jener Betriebsschwellen werden abschließend in den Eproms des Prüflings programmiert.

Im operationellen Betrieb überwacht der jeweilige Komparator die detektierte Pulsleistung gegen einen Referenzwert, welcher zuvor aus dem entsprechenden Eprom in das Eingangsregister des DA-Wandlers im Komparator geladen wurde.

In Fig. 2 ist eine beispielhafte Schaltung zur Durchführung des erfindungsgemäßen Verfahrens dargestellt. Die Schaltung umfasst einen Komparator K mit zwei Eingangstoren 1,2 und einem Ausgangstor A sowie einem Digital/Analog-Wandler D/A mit einem digitalen Eingangstor D_{E} und einem analogen Ausgangstor D_{A}. Das analoge Ausgangstor D_{A} ist mit einem Eingangstor 1 des Komparators K verbunden. Dem anderen Eingangstor 2 des Komparators K wird das zu wandelnde analoge Istsignal I_{S} zugeführt. Das Ausgangstor A des Komparators K ist mit einem elektronischen Bauteil KV zur Erzeugung eines digitalen Sollsignals DS_{S} verbunden, welches dem digitalen Eingangstor D_{E} des Digital/Analog-Wandlers D/A zugeführt ist. Das elektronische Bauteil KV ist dabei derart ausgeführt, dass es das digitale Sollsignal DS_{S} nach dem Wägeverfahren erzeugt.

Das von dem elektronischen Bauteil KV erzeugte digitale Sollsignal DS_{S} kann auch weiteren Komponenten (nicht dargestellt) zur Weiterverarbeitung zugeführt werden.

Mit der in Fig. 2 dargestellten Schaltung ist es z.B. möglich, im Kalibriermodus für einen RF-Detektor eines RF-Geräts einen Schwellwert für einen bestimmten Betriebsmodus zu generieren.

## Patentansprüche

1. Verfahren zur Wandlung eines analogen Istsignals (S_{I}) in ein digitales Sollsignal (DS_{S}) mittels eines zwei Eingangstore (1, 2) und ein Ausgangstor (A) aufweisenden Komparators (K) und eines integrierten Digital/Analog-Wandlers (D/A), wobei dem einen Eingangstor (1, 2) des Komparators (K) das zu wandelnde analoge Istsignal (S_{I}) und dem anderen Eingangstor (2, 1) des Komparators (K) das analoge Ausgangssignal (AS_{S}) des Digital/Analog-Wandlers (D/A) zugeführt wird, wobei das dem Digital/Analog-Wandler (D/A) zugeführte digitale Eingangssignal (DS_{S}) in Abhängigkeit vom dem am Komparatorausgang (A) anliegende Ausgangssignal des Komparators (K) in einer vorgebbaren Anzahl von Iterationsschritten zwischen einer vorgebbaren unteren und einer vorgebbaren oberen Schwelle nach einem Wägeverfahren angepasst und das dem Digital/Analog-Wandler (D/A) jeweils zugeführte digitale Eingangssignal (DS_{S}) dem digitalen Sollsignal (DS_{S}) entspricht in welches das analoge Istsignal (S_{I}) gewandelt wird,
**dadurch gekennzeichnet, dass**
das analoge Istsignal (S_{I}) einen Burst mit einer vorgebbaren Anzahl von Pulsen umfasst und dem Komparator (K) ein vorgebbarer Referenzpuls aus dem Burst zugeführt wird und dass im Komparator (k) ein Signalwert verarbeitet wird, der der Pulsmitte des Referenzpulses entspricht.

2. Verfahren nach Anspruch 1, **dadurch gekennzeichnet, dass** die Zahl der vorgebbaren Iterationsschritte der Bitlänge entspricht, mit der das digitale Sollsignal (DS_{S}) angegeben wird.

3. Verfahren nach einem der vorangehenden Ansprüchen, **dadurch gekennzeichnet, dass** das digitale Sollsignal (DS_{S}) verifiziert wird, derart, dass in einem ersten weiteren Iterationsschritt von dem analogen Istsignal (S_{I}) ein vorgebbarer Signalwert abgezogen wird, welches dann dem einen Eingangstor (2, 1) des Komparators (K) zugeführt wird und welches mittels des am Ausgang (A) anliegende Ausgangssignals des Komparators (K) auf Unterschreitung des am anderen Eingangstor (1, 2) des Komparators (K) anliegende, im Digital-/Analog-Wandler (D/A) aus dem zu verifizierenden digitalen Sollsignal (DS_{S}) erzeugte analoge Ausgangssignal (AS_{S}) des Digital-Analog-Wandlers (D/A) geprüft wird und dass in einem zweiten weiteren Iterationsschritt zu dem analogen Istsignal (S_{I}) ein entsprechend vorgebbarer Signalwert addiert wird, welches dann dem einen Eingangstor (2, 1) des Komparators zugeführt wird und welches mittels des am Ausgangstor (A) anliegenden Ausgangssignals des Komparators (K) auf Überschreitung des am anderen Eingangstor (1, 2) des Komparators (K) anliegende, im Digital-/Analog-Wandler (D/A) aus dem zu verifizierende digitalen Sollsignal (DS_{S}) erzeugte analoge Ausgangssignal (AS_{S}) des Digital-Analog-Wandlers (D/A) geprüft wird, wobei das digitale Sollsignal (DS_{S}) als korrekt angenommen wird, wenn der Prüfschritt im ersten und der Prüfschritt im zweiten weiteren Iterationsschritt erfolgreich war.

## Claims

1. Method for converting an analogue actual signal (S_{I}) into a digital desired signal (DS_{S}) using a comparator (K), which has two input gates (1, 2) and an output gate (A), and an integrated digital/analogue converter (D/A), the analogue actual signal (S_{I}) to be converted being supplied to one input gate (1, 2) of the comparator (K) and the analogue output signal (AS_{S}) from the digital/analogue converter (D/A) being supplied to the other input gate (2, 1) of the comparator (K), the digital input signal (DS_{S}) supplied to the digital/analogue converter (D/A) being adapted, on the basis of the output signal from the comparator (K) which is applied to the comparator output (A), in a predefinable number of iteration steps between a predefinable lower threshold and a predefinable upper threshold in accordance with a successive approximation method, and the digital input signal (DS_{S}) respectively supplied to the digital/analogue converter (D/A) corresponding to the digital desired signal (DS_{S}) into which the analogue actual signal (S_{I}) is converted,
**characterized in that**
the analogue actual signal (S_{I}) comprises a burst having a predefinable number of pulses, and a predefinable reference pulse from the burst is supplied to the comparator (K), and **in that** a signal value which corresponds to the middle of the reference pulse is processed in the comparator (K).

2. Method according to Claim 1, **characterized in that** the number of predefinable iteration steps corresponds to the bit length with which the digital desired signal (DS_{S}) is specified.

3. Method according to one of the preceding claims, **characterized in that** the digital desired signal (DS_{S}) is verified in such a manner that, in a first further iteration step, a predefinable signal value is subtracted from the analogue actual signal (S_{I}) which is then supplied to one input gate (2, 1) of the comparator (K) and is checked, using the output signal from the comparator (K) which is applied to the output (A), in order to determine whether the analogue output signal (AS_{S}) from the digital/analogue converter (D/A), which is generated in the digital/analogue converter (D/A) from the digital desired signal (DS_{S}) to be verified and is applied to the other input gate (1, 2) of the comparator (K), has been undershot, and **in that**, in a second further iteration step, a correspondingly predefinable signal value is added to the analogue actual signal (S_{I}) which is then supplied to one input gate (2, 1) of the comparator and is checked, using the output signal from the comparator (K) which is applied to the output gate (A), in order to determine whether the analogue output signal (AS_{S}) from the digital/analogue converter (D/A), which is generated in the digital/analogue converter (D/A) from the digital desired signal (DS_{S}) to be verified and is applied to the other input gate (1, 2) of the comparator (K), has been exceeded, the digital desired signal (DS_{S}) being assumed to be correct when the checking step in the first further iteration step and the checking step in the second further iteration step have been successful.

## Revendications

1. Procédé de conversion d'un signal réel analogique (S_{I}) en un signal de consigne numérique (DS_{S}) au moyen d'un comparateur (K) présentant deux portes d'entrée (1, 2) et une porte de sortie (A) et d'un convertisseur numérique/analogique intégré (N/A), dans lequel le signal réel analogique (S_{I}) à convertir est amené à ladite une porte d'entrée (1, 2) du comparateur (K) et le signal de sortie analogique (AS_{S}) du convertisseur numérique/analogique (N/A) est amené à ladite autre porte d'entrée (2, 1) du comparateur (K), dans lequel le signal d'entrée numérique (DS_{S}) amené au convertisseur numérique/analogique (N/A) est adapté en fonction du signal de sortie du comparateur (K) appliqué à la sortie de comparateur (A), dans un nombre prédéfinissable d'étapes d'itération, entre un seuil inférieur prédéfinissable et un seuil supérieur prédéfinissable selon un procédé de pondération, et le signal d'entrée numérique (DS_{S}) respectivement amené au convertisseur numérique/analogique (N/A) correspond au signal de consigne numérique (DS_{S}) en lequel est converti le signal réel analogique (S_{I}),
**caractérisé en ce que**
le signal réel analogique (S_{I}) comprend une rafale avec un nombre prédéfinissable d'impulsions et une impulsion de référence prédéfinissable provenant de la rafale est amenée au comparateur (K), et **en ce que** dans le comparateur (K), une valeur de signal est traitée qui correspond au centre d'impulsion de l'impulsion de référence.

2. Procédé selon la revendication 1, **caractérisé en ce que** le nombre des étapes d'itération prédéfinissables correspond à la longueur binaire avec laquelle le signal de consigne numérique (DS_{S}) est indiqué.

3. Procédé selon l'une quelconque des revendications précédentes, **caractérisé en ce que** le signal de consigne numérique (DS_{S}) est vérifié de telle sorte que dans une première étape d'itération supplémentaire, une valeur de signal prédéfinissable est soustraite du signal réel analogique (S_{I}), ledit signal étant ensuite amené à ladite une porte d'entrée (2, 1) du comparateur (K) et contrôlé au moyen du signal de sortie du comparateur (K) appliqué à la sortie (A) quant à un soupassement du signal de sortie analogique (AS_{S}) du convertisseur numérique/analogique (N/A) appliqué à ladite autre porte d'entrée (1, 2) du comparateur (K), généré dans le convertisseur numérique/analogique (N/A) à partir du signal de consigne numérique (DS_{S}) à vérifier, et **en ce que** dans une deuxième étape d'itération supplémentaire, une valeur de signal prédéfinissable de façon correspondante au signal réel analogique (S_{I}) est additionnée, ledit signal étant ensuite amené à ladite une porte d'entrée (2, 1) du comparateur et contrôlé au moyen du signal de sortie du comparateur (K) appliqué à la porte de sortie (A) quant à un dépassement du signal de sortie analogique (AS_{S}) du convertisseur numérique/analogique (N/A) appliqué à ladite autre porte d'entrée (1, 2) du comparateur (K), généré dans le convertisseur numérique/analogique (N/A) à partir du signal de consigne numérique (DS_{S}) à vérifier, dans lequel le signal de consigne numérique (DS_{S}) est supposé être correct lorsque l'étape de contrôle a réussi dans la première étape d'itération et l'étape de contrôle a réussi dans la deuxième étape d'itération supplémentaire.
